# EUROPEAN PATENT SPECIFICATION

(11) **EP 1 015 136 B1**
(45) Date of publication and mention of the grant of the patent: **07.09.2005**
(21) Application number: 98926126.8
(22) Date of filing: 29.05.1998
(51) Int. Cl.: B05D 3/12, B05D 3/02, B05C 13/00, B05C 13/02, H01L 21/469, B05C 11/08, B05D 1/00, G03F 7/16, H01L 21/312

(54) **METHOD AND APPARATUS FOR SPIN-COATING CHEMICALS**
VERFAHREN UND VORRICHTUNG ZUM ZENTRIFUGALBESCHICHTEN VON CHEMIKALIEN
PROCEDE ET APPAREIL DE REVETEMENT DE SUBSTANCES CHIMIQUES PAR ROTATION RAPIDE

(30) Priority: 30.05.1997 US 866832; 30.05.1997 US 866834
(43) Date of publication of application: 05.07.2000
(73) Proprietor: SUSS MicroTec Lithography GmbH, 85748 Garching (DE)
(72) Inventor: MAHNEKE, Peter, D-21244 Muchholz (DE); BATCHELDER, William, T., Oakland, CA 94605 (US)
(74) Representative: Vossius & Partner
(86) International application number: PCT/US1998/010958
(87) International publication number: WO 1998/053923

(56) References cited:
- US-A- 4 113 492
- US-A- 4 518 678
- US-A- 4 838 289
- US-A- 5 439 519
- US-A- 5 474 807
- US-A- 5 705 223

## Description

### BACKGROUND OF THE INVENTION

### 1. Field of the Invention

The present invention relates generally to semiconductor fabrication, and more particularly, to apparatuses and methods for spin-coating substrates used in the fabrication of semiconductor devices.

### 2. Description of the Related Art

The fabrication of a large variety of solid state devices such as semiconductors requires the use of planar substrates, otherwise known to those skilled in the art as wafers. An important consideration in the fabrication of these devices is the final number (*i.e*., yield) of functional dies remaining from each manufactured wafer. The functional dies are packaged, undergo testing (both electrical and otherwise), and substantially all of the packaged dies that pass the requisite testing are sold. It is therefore of utmost importance for manufacturers of these products to take advantage of economies of scale realized by increasing their production yield. Typically, depending on the individual die dimensions, upwards of 1000 or more dies may be fabricated on a single wafer. These wafers are typically on the order of six to twelve inches in diameter.

A typical fabrication process requires numerous steps, where several layers of material are cumulatively applied and patterned on the surface of the wafer. Once complete, these layers form the desired semiconductor structure necessary for the resulting circuit, or device. As can be appreciated, the final functional yield critically depends upon the proper application of each layer during the various process steps. Proper application of these layers typically depends, in turn, upon the ability to form uniform coatings of material on the surface of the wafer in an efficient, environmentally benign, and production worthy manner.

Various fabrication process steps implemented in making semiconductor devices utilize photolithography to define the desired patterns on the surface of a wafer. As is well known, photolithography is the process where light energy is applied through a reticle mask (using a stepper exposure camera) onto a photoresist material that is applied to the wafer to define patterns where subsequent etching will occur. These surface patterns represent a two dimensional layout of the desired structure that is fabricated on the surface of the wafer. It is therefore important that the photoresist material be applied in uniformly distributed coatings, while at the same time ensuring that particulate generation is minimized. As is well known in the art, when particulate generation is minimized or eliminated, it is possible to increase the resolution of the desired patterns, as well as increase pattern density.

Conventionally, the application of photoresist coatings on the surface of a wafer is accomplished by casting a photoresist fluid on a wafer that is spinning at high speeds within a stationary exhausted bowl. In general, the stationary exhausted bowl is used to catch any excess fluids and remove particulates. Once the photoresist fluid is applied, the centrifugal force that result from the high rotational speed of the wafer overcomes the surface tension of the photoresist fluid, which causes the photoresist fluid to spread over the surface of the wafer.

A side effect of spinning the wafer is the inducement of air flows in the air immediately above and adjacent to the wafer surface. Unfortunately, this air flow tends to induce particles of photoresist to leave the wafer surface at the wafer's edge. When the photoresist leaves the wafer's edge, the free floating photoresist particulates have the potential to back contaminate the remainder of the wafer surface where a fresh coating of photoresist has just been applied. Although these particles may be removed by an exhaust system that may be part of the stationary bowl, the exhaust has the undesirable effect of drying out photoresist solvent films unevenly and, thus, producing a non-uniform coating of photoresist over the surface of the wafer during the spinning process. Back side contamination of the photoresist film with photoresist particulates and uneven drying of the photoresist film are therefore, undesirable yield reducing side effects of conventional spin-coating processes.

Another problem associated with conventional spin coating methods is photoresist fluid beading at the outer edge of the spinning wafer. Specifically, it is believed that surface tension and adhesion of the photoresist film to the wafer surface experienced during spinning causes the photoresist to from a "zone of increased thickness" at the edge of the wafer. This beading can typically contribute to a significant loss in functional devices that lie at and near the outer edge of the wafer.

Yet another problem associated with the beading effect at the edges of the wafers is that wafers are commonly stored in cassettes and, the increased thickness at the edges has the unfortunate effect of fracturing the wafers when they come in contact with the storage cassette. Of course, when wafers are fractured in any way, an instant loss in yield is experienced.

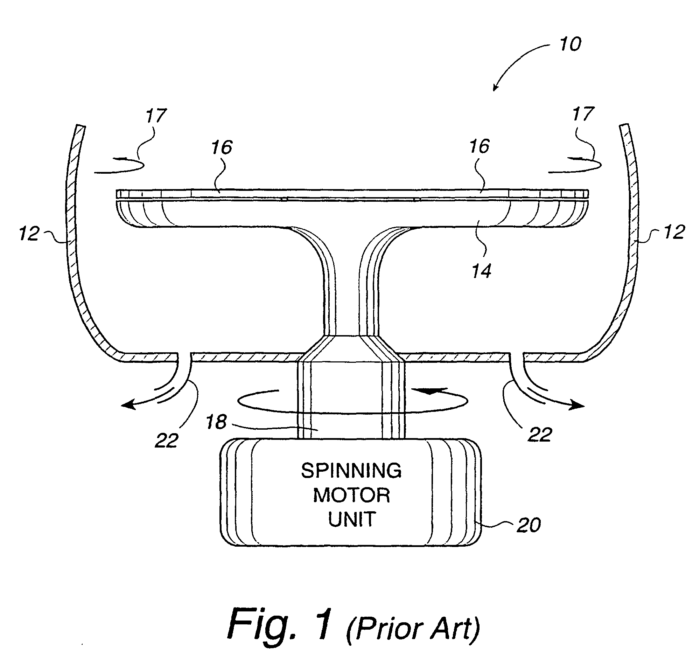

Figure 1 is an illustration of a conventional open bowl apparatus 10 for spin coating a wafer 16. A wafer 16 is typically placed upon a rotatable chuck 14 which is rigidly connected to a spinning motor unit 20 by a shaft 18. As shown, the spinning chuck 14 and the wafer 16 are located within an open stationary bowl 12. The open stationary bowl 12 may include suitable exhaust passages 22 that are used to purge out particulates that may be produced within open stationary bowl 12 during a spin coating process. Unfortunately, conventional methods for removing particulates produced during spin coating operations have been less than adequate.

During a spin coating operation, a number of air flows 17 may be produced in the air immediately above and adjacent to the spinning chuck 14. As described above, the air flows 17 tend to produce particles of photoresist that further complicate the back contamination problems described above.

In view of the foregoing, there is a need for apparatuses and methods that facilitate the application of substantially uniform spin coated materials over the surface of a wafer while reducing the amount of yield reducing particulates.

### SUMMARY OF THE INVENTION

Broadly speaking, the present invention fills these needs by providing a method and an apparatus for uniformly spin-coating materials over the surface of a substrate, such as wafers.

According to the present invention, an apparatus for spin coating chemicals over a substrate is disclosed as defined in appended claim 1. The apparatus includes a bowl having a raised support for holding the substrate. The bowl includes curved walls that define a cavity capable of holding a fluid near an outer region of the bowl. The apparatus further includes a lid configured to mate with the curved walls. The lid preferably has a substantially flat underside that is positioned in close proximity to a top surface of the substrate. Further, the apparatus includes fluid injector holes defined along an ejection ring that is defined under the substrate. The fluid injector holes are directed at an underside of the substrate that is near the outer diameter of the substrate. The apparatus also includes a plurality of drain holes that are defined on a floor region of the bowl. The plurality of drain holes are spaced apart from the outer region of the bowl to enable the cavity to hold a fluid while the bowl is spinning, and to drain the fluid when the bowl begins to come to a substantial stop.

A method for spin coating a substrate in accordance with the present invention is also disclosed as defined in appended claim 28. The method includes applying a chemical to be spin coated over a substrate that is supported within a bowl. The bowl has a fluid retaining cavity at an outer edge of the bowl. The method further includes encapsulating the substrate in the bowl, and spinning the encapsulated bowl to cause the applied chemical to be spin coated over the surface of the wafer. Further, the method includes injecting a solvent to an underside edge of the wafer to remove an excess chemical beading from the edge of the wafer, and collecting the solvent and the excess chemical beading that flows off of the substrate in the fluid retaining cavity while the encapsulated bowl is spinning. Further, the method includes draining the excess chemical beading and the solvent that is collected in the fluid retaining cavity when the encapsulated bowl nears a non-spinning state.

An advantage of the present invention is that the lid is configured to enclose the wafer and seal out the environment above the wafer surface during a spin coating process. The plurality of injection holes defined in the floor of the spinning bowl are well suited for applying a solvent to the underside of the wafer to rinse the edge of the wafer to prevent edge beading of the applied chemicals (*e*.*g*., photoresist, SOG, and other spun on dielectrics). Generally, the solvent that is applied to the underside of the wafer is driven into the spinning bowl by the centrifugal forces produced when the bowl is spinning. Accordingly, the applied solvent may also be used to clean the inside of the bowl after each spin coating operation to reduce chemical build up, which may cause yield reducing defects.

Furthermore, the fluid retaining cavity according to the present invention in the bowl is well suited to hold any excess chemicals that are spin coated over the wafer as well as any solvent material that may be applied to the underside of the wafer. Preferably, substantially all fluids are retained within the cavity while the bowl is spinning, and when the bowl comes to a stop, the fluids may drain out through drain holes defined in the floor of the bowl. As an additional advantage, by capturing the fluids within the cavity during a spin coating operation, substantially less yield reducing particulates are produced. In a further embodiment, an extension of the bowl is well suited to form a labyrinth with a splash ring of a catch cup, and thereby substantially further reduce the possibility of air borne particulates outside to the bowl/catch cup system.

Other aspects and advantages of the invention will become apparent from the following detailed description, taken in conjunction with the accompanying drawings, illustrating by way of example the principles of the invention.

### BRIEF DESCRIPTION OF THE DRAWINGS

The present invention will be readily understood by the following detailed description in conjunction with the accompanying drawings.
Figure 1 not according to the present invention is a cross-sectional view of a substrate spin coated in a conventional open bowl arrangement.
Figure 2A not according to the present invention is an exploded view of a rotatable bowl and a lid.
Figure 2B not according to the present invention is a top view of a rotatable bowl.
Figure 2C not according to the present invention is a cross-sectional view showing the rotatable bowl containing a wafer and a locking shaft for mechanically applying and removing the lid to the rotatable bowl.
Figure 2D not according to the present invention is a top view of the lid used.
Figures 2E not according to the present invention is an enlarged side view of a portion of a rotatable bowl having a fluid drain hole.
Figure 2F not according to the present invention is a diagrammatic cross-sectional view of a wafer during a typical spin coat cycle.
Figure 2G not according to the present invention is a cross sectional view of a wafer having a substantially uniform coating layer after a spin coating procedure.
Figures 3 not according to the present invention illustrates an exemplary spin coating system including a catch cup.
Figure 4A is an exploded view of a rotatable bowl and a lid in accordance with the present invention.
Figure 4B is a side cross sectional view of the rotatable bowl of Figure 4A in accordance with the present invention.
Figures 4C is an enlarged side view the rotatable bowl of Figure 4B illustrating a cavity for holding fluids during a wafer spin coating operation in accordance with the present invention.
Figure 5A is a cross sectional view of the applied coating fluid captured in the cavity during the spin coating operation in according with the present invention.
Figure 5B is a cross sectional view of the applied coating after a solvent back rinse operation is performed in accordance with the present invention.
Figures 6A is an exemplary spin coating system including a catch cup and splash rings in accordance with the present invention.
Figures 6B is a magnified cross sectional view of a labyrinth formed by an extension of the rotatable bowl and a splash ring of the catch cup of Figure 6A in accordance with the present invention.

### DETAILED DESCRIPTION OF THE PREFERRED EMBODIMENTS

An invention for a closed semiconductor process bowl that provides improved spin coat uniformity is disclosed. Although the present invention is particularly well suited for the application of photoresist materials, other chemicals such as spin-on-glass (SOG) may also find the application process well suited to improve coating uniformity. The various embodiments of the present invention may be implemented in any form, and may find particular use in the application of both high viscosity and lower viscosity materials to the surface of a planar wafer. In the following description, numerous specific details are set forth in order to provide a thorough understanding of the present invention. It will be obvious, however, to one skilled in the art, that the present invention may be practiced without some or all of these specific details. In other instances, well known process operations have not been described in detail in order not to unnecessarily obscure the present invention.

In accordance with the present invention, a closed process bowl is disclosed where chemicals are spin coated over a substrate during a fabrication process. In a preferred embodiment, the substrate is a wafer that may be used to make semiconductor devices. Generally, the wafer is placed on a rotatable bowl that is rigidly affixed to a motor driven shaft. During the coating process, a chemical such as photoresist is applied to the surface of the wafer before a lid is secured to the rotatable bowl having curved walls. The spinning of the bowl causes the chemical to spread over the surface of the wafer.

To combat the aforementioned edge beading problems, a solvent is preferably injected on the back side (*i.e.*, back side rinse) of the spinning wafer near its outer diameter after the photoresist has spread over the surface of the wafer. Preferably, the solvent is injected through a plurality of solvent injector holes that extend from an outer surface of the rotatable bowl to an interior region of the rotatable bowl. When applied, the solvent is forced into the rotatable bowl by the centrifugal force produced by the spinning action. In one embodiment, the applied solvent acts to substantially reduce beading at the outer regions of the wafer. Further, the applied solvent also acts to reduce particle contamination to the under surface of the wafer.

Preferably, the bowl containing the coated wafer is spun while the solvent is applied to the surface of the wafer to complete the top side rinse. Any solvent chemicals that spin off of the surface of the wafer while the bowl is spinning are therefore allowed to exit the bowl through the aforementioned drain holes that are positioned below the surface height of the wafer when the bowl comes to rest. The back side rinse and top side rinse operations have the advantageous effect of cleaning the inner regions of the bowl of excess photoresist in addition to providing superior edge bead removal in a controlled environment.

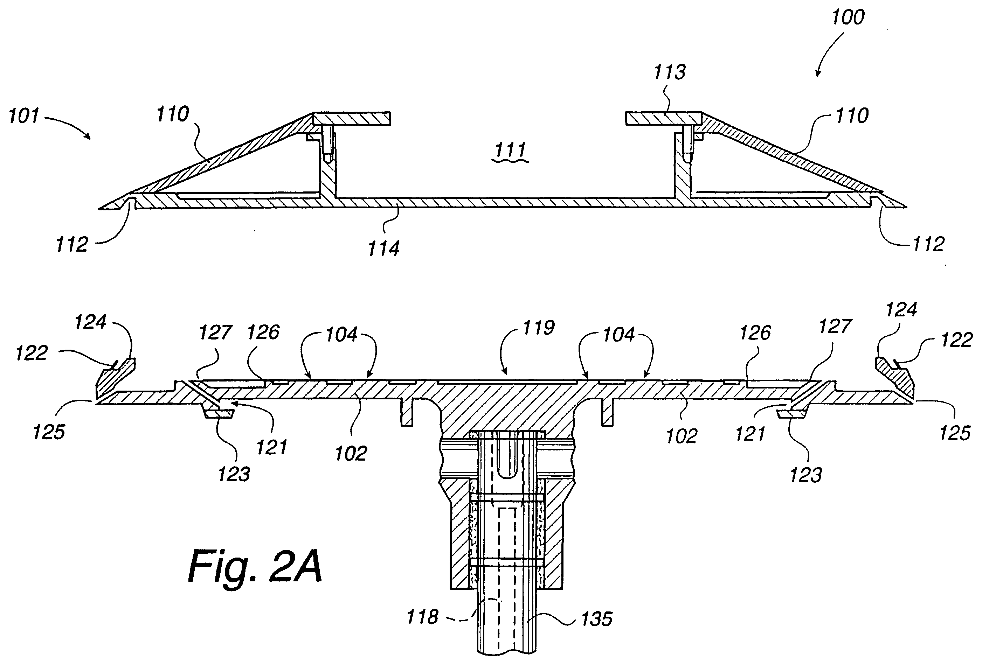

Figure 2A is not according to the present invention. It helps, however, to the understanding of the claimed invention. It shows an exploded view of a closed semiconductor process system 100 including a bowl 102 and a lid 101. The lid 101 preferably has a circular shape having an upper beveled surface 110, a lower flat surface 114, and a hollow internal region 111 that is accessible through a top opening 113. In accordance with the present embodiment, the bowl 102 is integrally connected to a motor driven axial shaft 135. As shown, the axial shaft 135 has an axially located vacuum chamber 118 extending substantially along the length of axial shaft 135 and terminating in a vacuum orifice 119. Vacuum orifice 119 is preferably centrally located on a support surface 104 of bowl 102.

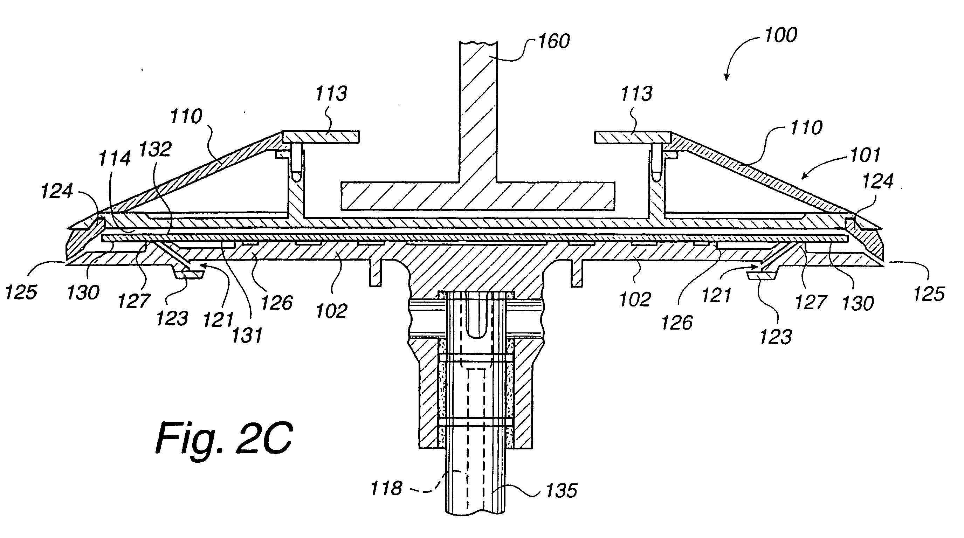

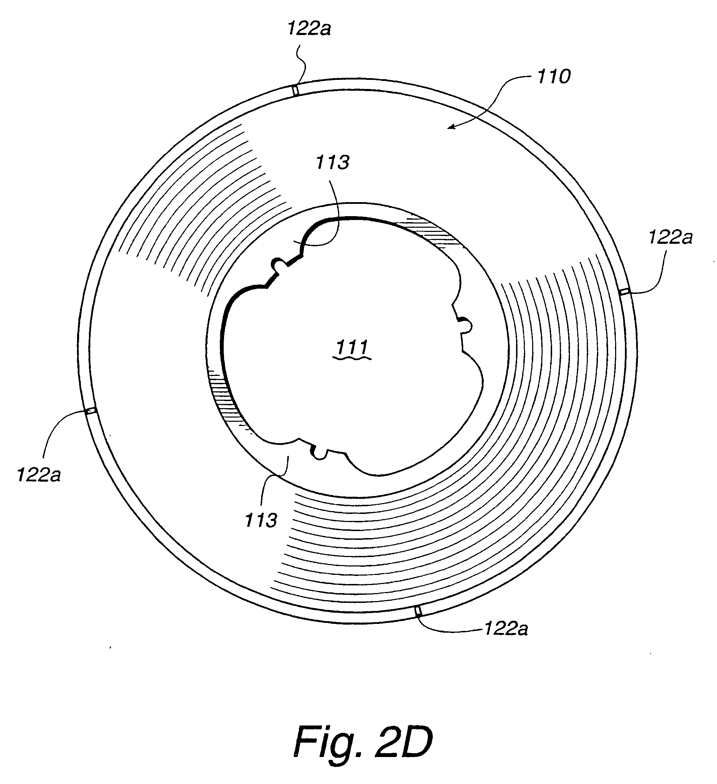

As shown, support surface 104 of bowl 102 is preferably configured to hold a suitable workpiece. In a preferred embodiment, the work piece is a silicon wafer used in the fabrication of semiconductor integrated circuits. However, it should be appreciated that the various embodiments of the present invention may be equally applicable to other technologies where precision chemical spin-coating is desirable (*i*.*e*., photoresist, spin-on-glass (SOG), compact disc recordable (CDR) dye chemicals, etc.). Generally, a support ring 126 defines the outer circumference of support surface 104 of bowl 102 and is configured to support a wafer 130, as shown in Figure 2C. In this example, lid 101 will preferably have a circular recessed groove 112 defined in the lower flat surface 114. Circular recessed groove 112 is preferably configured to mate with a circular protruded lip 124 that is located around the outer wall portions of bowl 102.

Also shown are a plurality of drain holes 125 that are arranged at the outer radius of bowl 102. Preferably, drain holes 125 are vertically lower than support surface 104. In this manner, when wafer 130 is placed over support surface 104, the wafer lies above drain holes 125. Because chemicals that are applied to the surface of a spinning wafer slide off of the wafer at high rates, the chemicals will preferably be channeled down and along the curved walls to the drain holes 125. As such, this curved wall surface is well suited to receive the chemicals being released from the wafer surface in a manner that directs the chemicals out of the closed bowl system. Preferably, between about 8 and about 16 drain holes 125 are defined around the outer radius of bowl 102 to enable the applied chemicals to exit during a spin coating cycle. In this embodiment, drain holes 125 are between about 1 mm and about 3 mm in diameter. Of course, the diameter may be modified to suit depending on the viscosity of the applied chemicals and the solvent materials injected in through injection holes 121. In any event, drain holes 125 are generally large enough to ensure that a sufficient pathway is defined to drain out the injected solvent and dissolved coating materials.

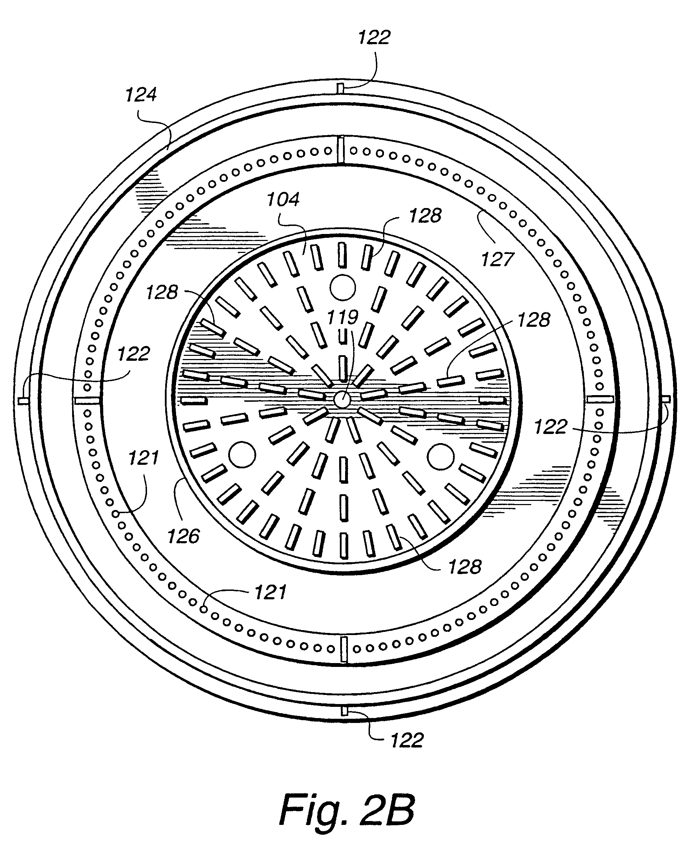

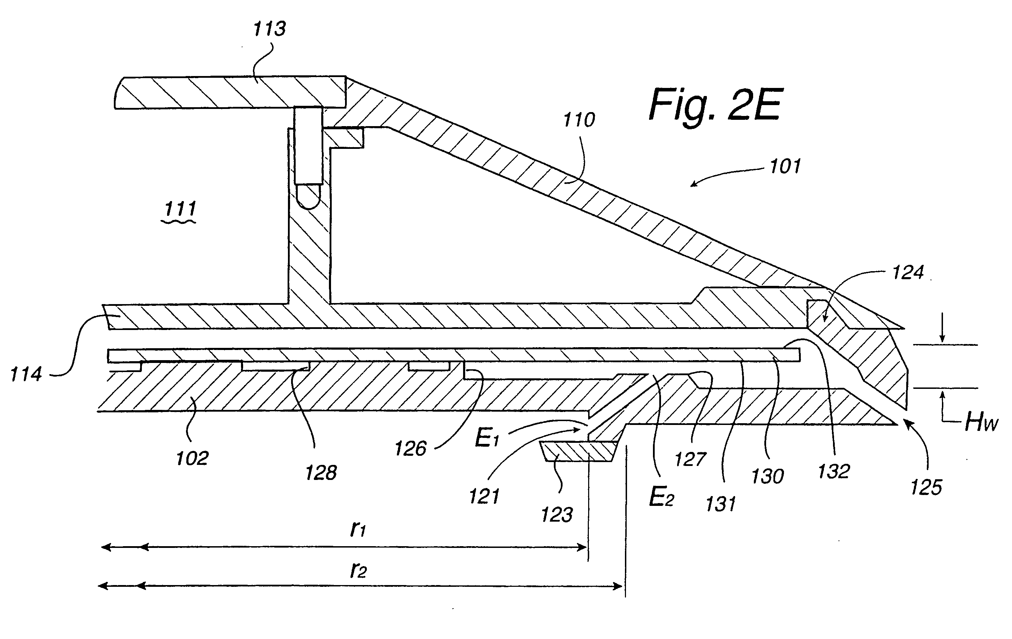

Figure 2B is a top view of bowl 102 as illustrated in Figure 2A. As shown, support surface 104 of bowl 102 has a plurality of supports 128 that extend radially outward from the centrally located vacuum orifice 119 to the support ring 126. Supports 128 are used to support the substrate that is held in place by vacuum suction supplied by vacuum orifice 119 and vacuum chamber 118. A plurality of locking pins 122 are shown arranged around the top portion of bowl 102 to assist in securing lid 101 to bowl 102. Generally, locking pins 122 are configured to mate with suitable recessed pin holes 122a located on lid 101 as shown in Figure 2D below. Of course, other suitable lid attachment techniques will work as well. This view also provides a good illustration of a plurality of solvent injector holes 121 that are defined on a solvent ejector ring 127. In one embodiment, about 100 solvent injection holes 121 are defined around the solvent ejector ring 127 for applying solvent chemicals used in back side rinse operations. The back rinse function of solvent injector holes 121 will be described in greater detail with reference to Figure 2E.

Figure 2C shows a wafer 130 placed upon support surface 104 of bowl 102 in accordance with Figures 2A and 2B. As described above, a vacuum supplied by a vacuum pump (not shown) is coupled to the vacuum chamber 118 which leads to the support surface 104 for securing wafer 130 during operation. In this view, the lid 101 has been coupled to bowl 102 in order to encapsulate wafer 130. Preferably, the lower flat surface 114 of lid 101 is separated from the upper surface 132 of wafer 130 by a distance that is small enough to reduce convective vortices from forming near the surface lying above the spinning wafer. In one embodiment, the distance is between about 1 mm and about 10 mm, and more preferably, between about 1.5 mm and about 3 mm, and most preferably about 2 mm.

During a spin coating operation, a coating material is preferably applied to the inner radius of the upper surface 132 of wafer 130 before lid 101 is secured to the bowl 102. After the coating material has been applied, lid 101 is secured to bowl 102 by mating circular recessed groove 112 to circular protruded lip 124 as described above. In one embodiment, axial shaft 135 is connected to a motor (not shown) that preferably rotates axial shaft 135 to operational speeds sufficient to spread the coating materials.

To ensure that lid 101 remains secured to bowl 102 during rotation, a locking shaft 160 is secured to lid 101. In addition, locking shaft 160 is used to mechanically apply and remove lid 101 from bowl 102 during and between spin coating cycles. As shown by Figure 2D, opening 113 defines a shape that is configured to receive locking shaft 160 (having a similar shape) into hollow internal region 111. Once the locking shaft 160 is lowered into hollow internal region 111, locking shaft 160 is rotated approximately 120 degrees in either direction. In this manner, the now opposing shapes of the locking shaft 160 and opening 113 prevent lid 101 from detaching during spin coating. From this top view of lid 101, the plurality of recessed pin holes 122a are shown defined along the outer diameter of lid 101 such that the plurality of pins 122 illustrated in Figures 2A and 2B mate with the plurality of pin holes 122a.

As described above and illustrated in Figure 2E, bowl 102 includes a plurality of solvent injection holes 121. Solvent injection holes 121 have one end E₁ defined within a solvent injector ring 123 that is located a radial distance r₁ from the center of rotation of bowl 102. Further, an internal end E₂ of the solvent injection holes 121 is located at about a radial distance r₂ from the center of rotation of bowl 102. Generally, radial distance r₁ is less than radial distance r₂, therefore the injector holes 121 form angled conduit paths (*e*.*g*., between about 30 and 50 degrees) through bowl 102, connecting solvent injector ring 123 and solvent ejector ring 127. In a preferred embodiment, solvent ejector ring 127 has a diameter that extends about 150 mm. As described above, solvent that is passed in through the injector holes are well suited to complete back side rinsing of wafer 130, thereby reducing the possibility of edge bead formation.

It should also be appreciated that wafer 130 is positioned a distance "Hw" above drain holes 125. In one embodiment, the distance Hw is at least between about 3 mm and about 5 mm, and more preferably at least between about 3 mm and about 4 mm, and most preferably at least about 3 mm. In this manner, chemicals that are spun off of the surface of wafer 130 are preferably not reflected back onto the surface of wafer 130. As described above, the inner wall surface of bowl 102 is preferably curved enough to allow chemicals to slide off wafer 130 and down the wall surface toward drain holes 125. A further advantage of having the drain holes 125 below the top surface 132 of wafer 130 is that any turbulence flows produced near the inner edge of bowl 102 is preferably contained below wafer 130. When turbulent flows are directed away from the surfaced wafer 130, the spun on coatings are produced with improved uniformity, thereby reducing yield reducing imperfections.

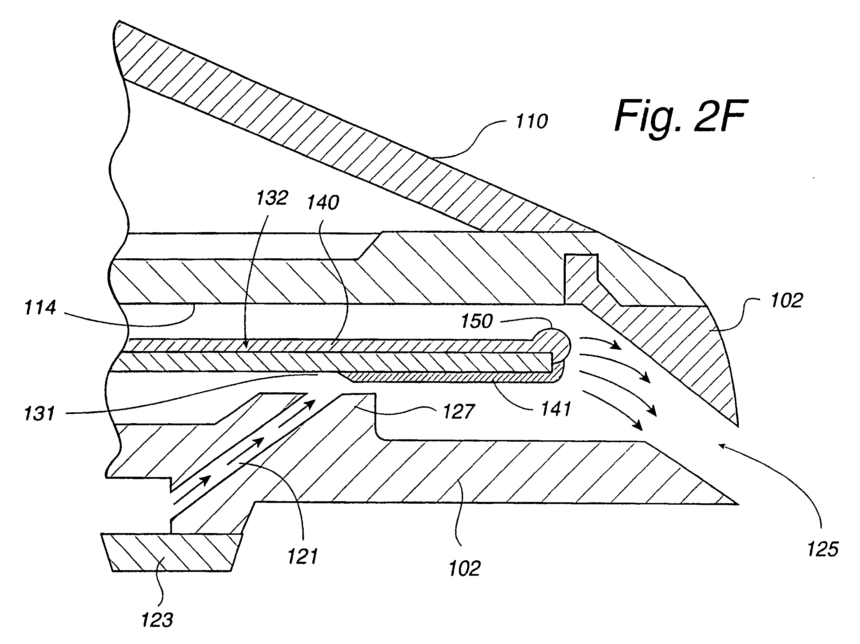

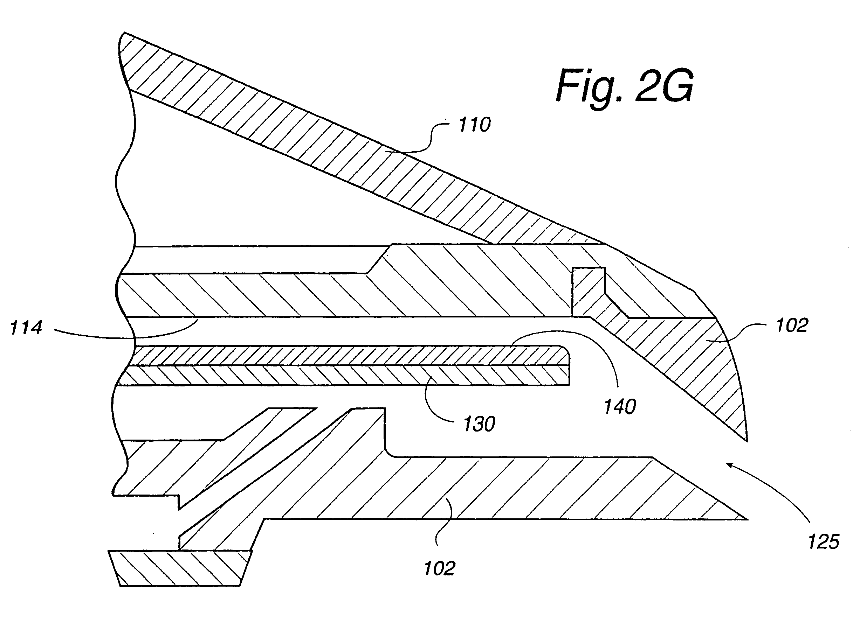

Figure 2F shows a cross sectional view of wafer 130 during a typical spin coat procedure. As bowl 102 rotates, the produced centrifugal forces assist the coating material in spreading over the surface 132 of wafer 130, thereby forming a coating layer 140. Unfortunately, the typical coating procedure produces a beading 150 at the edge of wafer 130. As described above, beading 150 presents a number of undesirable yield reducing problems. To reduce the possibility of beading 150, a solvent material is injected in through solvent injector 121 and applied as a temporary solvent coating 141. In this example, the solvent coating 141 is caused to spread out towards the beading 150 by the same centrifugal forces that spread coating layer 140. Accordingly, the solvent coating 141 assists in dissolving beading 150 to produce a more uniformly coated edge. The dissolved coating material and excess solvent will then flow out of bowl 102 through drain holes 125 as described above. Figure 2G is a diagrammatic cross sectional view of wafer 130 having the spun on coating material layer 140 after the solvent coating 141 was applied to remove beading 150. As shown, the coating layer 140 is now more uniform throughout the surface of wafer 130.

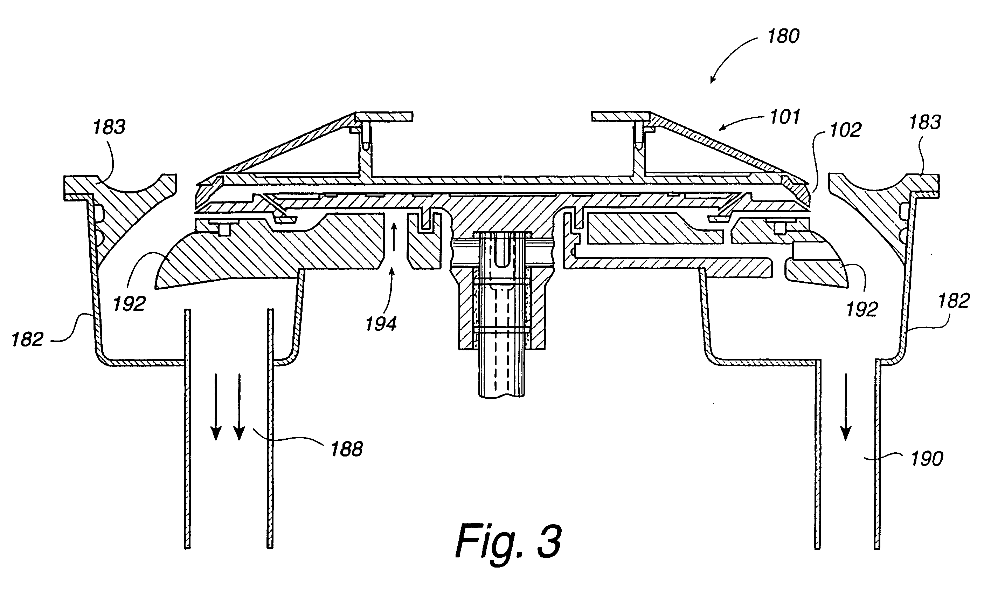

Figures 3 is not according to the present invention. It helps, however, to the understanding of the claimed invention. It illustrates an spin coating system 180 that may be used in conjunction with the closed bowl spin coating system described above. As shown, bowl 102 and lid 101 are preferably assembled within a catch cup 182. Catch cup 182 may include a splash ring 183 that is used to block particulates generated out of drain holes 125 from exiting catch cup 182. Catch cup 182 also includes a drain hole 190 that is well suited to channel chemicals out of catch cup 182 and into a drain manifold (not shown). An exhaust manifold 188 may also be provided to assist in the removal of air borne particulates. A HEPA filter (not shown) may also be positioned above spin coating system 180 to capture any particulates that may escape catch cup 182. In the embodiment shown, a plenum 192 is coupled to bowl 102 to provide a channel 194 used for applying the aforementioned solvent chemicals to the solvent injector holes 121. In addition, plenum 192 provides a surface for receiving the exhaust manifold 188. Of course, any number of well known exhaust manifolds 188 may be implemented as well.

According to the present invention for a closed semiconductor process bowl that reduces particulate generation and provides improved spin coat uniformities is disclosed. Although the present invention is particularly well suited for the application of photoresist materials, other chemicals, such as, spin-on-glass (SOG) and spin-on-dielectrics (SODs) may also find the application processes described herein particularly advantageous for achieving improved coating uniformities and reducing particulates. Furthermore, the various embodiments of the present invention may be implemented in any form, and may find particular use in the application of both high viscosity and lower viscosity materials.

Any dissolved coating material and excess solvent that is produced during a spin coating process is preferably captured in a concave region located at an interior edge of the bowl, while the spin coating process is in progress. Once spin coating is complete (*e.g.*, the spinning bowl comes to a substantial halt), the captive dissolved coating material and excess solvent are allowed to flow out of the spinning bowl through drain holes that are located on the lower surface of the bowl. That is, while the bowl is spinning, the centrifugal force acts to holds the dissolved coating material in the concave region. However, once the centrifugal forces diminish, the liquid will be allowed to flow out of the closed bowl system. It should be appreciated that substantially all particulates are advantageously contained within the closed bowl system during the spin coat operation, thereby reducing backside contamination problems as well as environmental contamination.

In accordance with a further embodiment of the present invention, the back side and sometimes top side edge bead removal (EBR) process steps enable the generation of substantially uniform coatings within a controlled environment that reduces particulate generation. Furthermore, the EBR process steps advantageously assist in automatically rinsing the bowl after each coating operation. Of course, maintaining the bowl clean during a spin coating session is particularly important to reduce the possibility of contaminating current wafers with particulates of previous spin coating sessions.

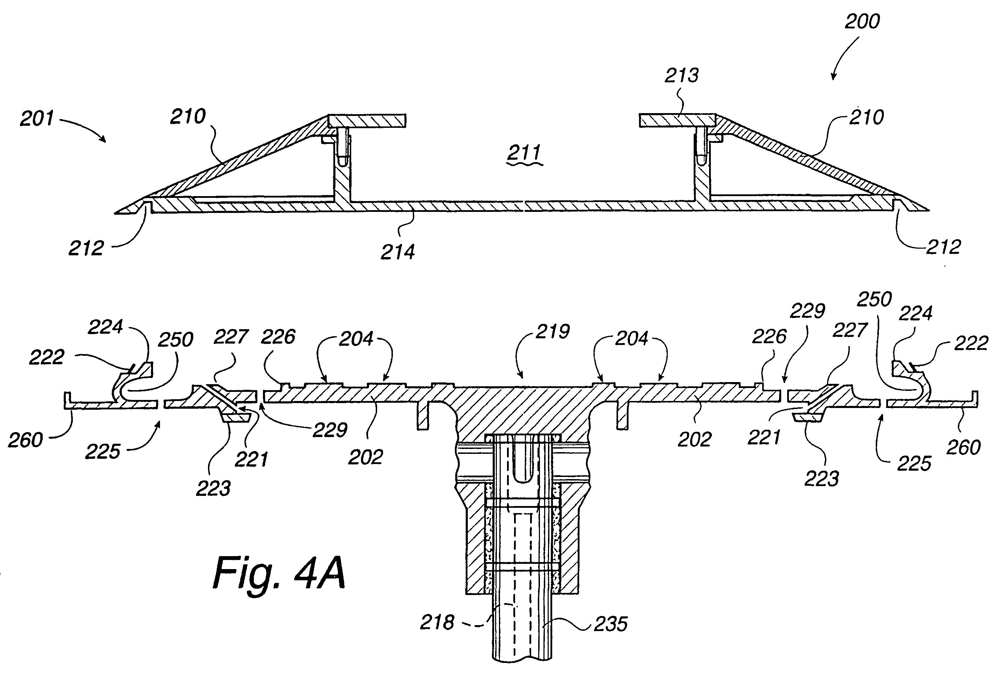

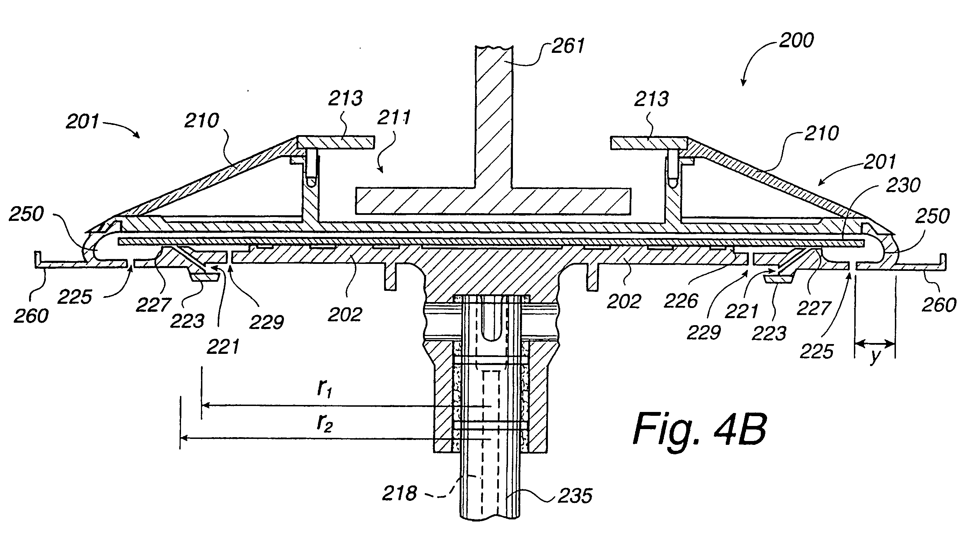

Figure 4A is an exploded view of a closed semiconductor process bowl 200 including a bowl 202 and a lid 201, and Figure 4B is an assembled view in accordance with the present invention. In this embodiment, the lid 201 preferably has a circular shape with an upper beveled surface 210, a lower flat surface 214, and a hollow internal region 211 that is accessible through a top opening 213. Preferably, the bowl 202 is integrally connected to a motor driven axial shaft 235 that includes an axially located vacuum chamber 218 extending along the length of the axial shaft 235 and terminating in a vacuum orifice 219. Vacuum orifice 219 is preferably centrally located within bowl 202 for securing wafers to a support surface 204.

As shown in Figure 4B, support surface 204 of bowl 202 is well suited to hold a wafer 230 during spin coating operations. In a preferred embodiment, the substrate is a silicon wafer used in the fabrication of semiconductor integrated circuits. However, it should be appreciated that the various embodiments of the present invention may be equally applicable to other technologies where precision chemical (*i.e*., photoresist, spin-on-glass (SOG), spin-on-dielectrics (SODs), compact disc recordable (CDR) dye chemicals, mask plates, liquid crystal display panels, multi-chip carriers, etc.) spin-coating is desirable. In this embodiment, a support ring 226 defines the outer diameter of support surface 204. In this example, lid 201 will preferably have a circular recessed groove 212 defined in the lower flat surface 214. Circular recessed groove 212 is preferably configured to mate with a circular protruded lip 224 that is located around the outer portion of bowl 202. Further, a separation of between about 1 mm and about 10 mm is preferably defined between the lower flat surface 214 of lid 201 and the top surface of wafer 230, and more preferably, the separation is between about 1.5 mm and about 3, and most preferably about 2.

As mentioned above, bowl 202 preferably includes a cavity 250 for holding any dissolved coating material and excess solvent during the spin coating process. Therefore, while bowl 202 and lid 201 are spinning, the centrifugal forces will hold the excess liquid in cavity 250, and when the forces diminish, the liquid will preferably flow out through a plurality of drain holes 225. Preferably, between about 8 and about 16 drain holes 225 are defined along the floor of bowl 202 to enable the applied chemicals to exit after a spin coating application.

Referring to Figure 4B, bowl 202 also includes a plurality of solvent injection holes 221 that have a first end located within a solvent injector ring 223 (at a radial distance r₁ from the center of bowl 202), and a second end located approximately at the mid-line of a solvent ejector ring 227 (at a radial distance r₂ from the center of bowl 202). Generally, radial distance r₁ is less than radial distance r₂, therefore solvent injection hole 221 forms an angled conduit (*e*.*g*., between about a 30 and 50 degrees) through bowl 202 connecting solvent injector ring 223 and solvent ejector ring 227.

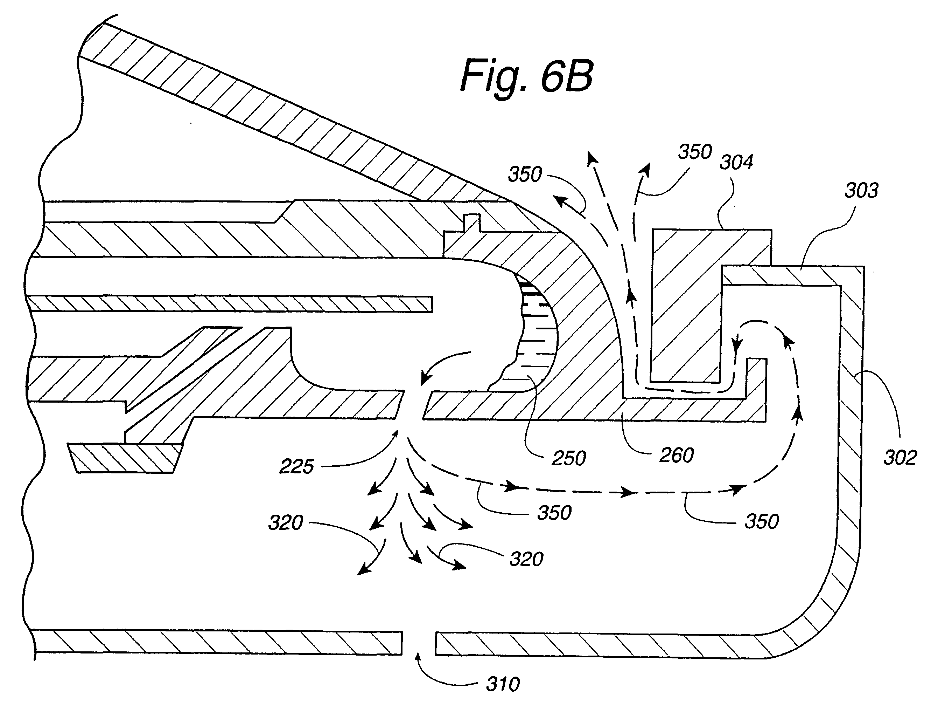

Bowl 202 also includes a circular extension 260 that extends from the outer region of bowl 202 to reduce the possibility of particulate contamination. As will be described in greater detail below with reference to Figure 6B, circular extension 260 forms a labyrinth with a stationary catch cup splash ring to prevent substantially all generated particulates from exiting the system and contaminating the spin coated chemicals.

To ensure that lid 201 remains secured to bowl 202, a locking shaft 261 is placed near the lower surface 214 of lid 201. By way of example, locking shaft 261 conforms to the shape of the top opening 213 of lid 201, thereby accessing hollow internal region 211. Once inserted into hollow internal region 211, locking shaft 261 is rotated approximately 120° in either direction. In this manner, locking shaft 261 is firmly affixed near the lower surface 214 of lid 201 to ensure that lid 201 does not detach during a spin coating process.

Additionally, a plurality of locking pins 122/222 shown in Figures 4A and 2B are arranged about the top portion of the walls of bowl 202 to assist in securing lid 201 during processing. Generally, locking pins 122/222 are configured to mate with suitable recessed pin holes located on the underside of lid 201. In another embodiment, lid 201 may include magnetic latches (not shown) for securing lid 201 to bowl 202. Generally, the magnetic latches may be composed of a plurality of attracting magnet pads that are well balanced along the top portion of the walls of bowl 202 and along the underside of the lid 201. In this manner, the magnet pads of the bowl 202 and the lid 201 are not required to mate in the same fixed orientation each time the lid 201 is applied to the bowl 202. As an advantage, a more rapid sealing of bowl 202 may be performed which, in some cases, may prevent premature drying of the chemicals that applied to the wafer 230.

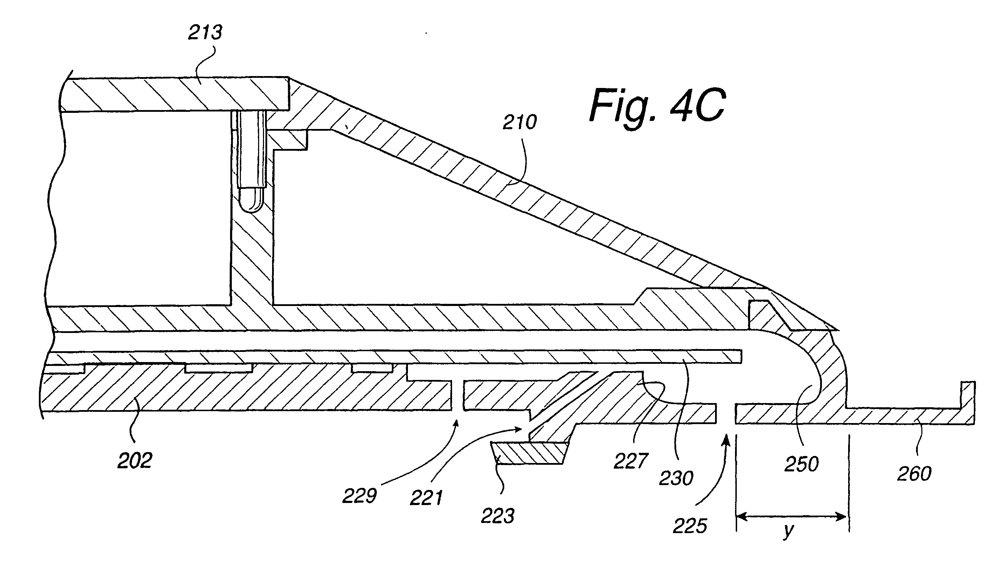

Figure 4C is a magnified cross sectional view of Figure 4B having the plurality of drain holes 225 spaced a distance "*y*" from the outer edge of bowl 202 (excluding circular extension 260). In this manner, the plurality of drain holes 225 (being between about 1 and 3 mm in diameter) lie under wafer 230 to ensure that cavity 250 will hold the excess solvent and dissolved photoresist during a spin coating operation. For this reason, cavity 250 is preferably large enough to accommodate a volume of between about 10 cubic centimeters and about 20 cubic centimeters.

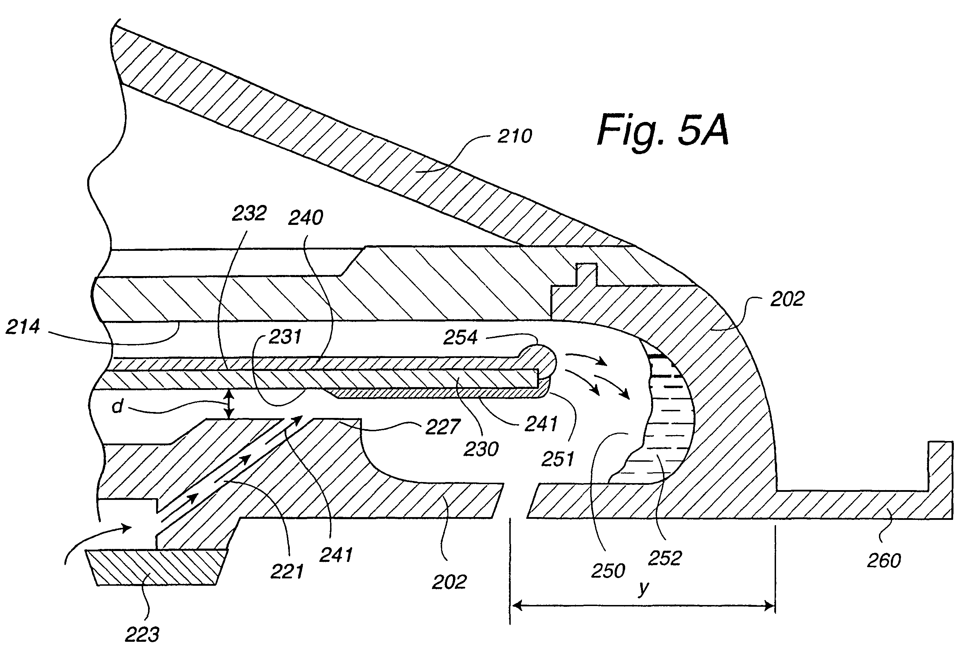

Figure 5A is a more magnified view of cavity 250 holding solvent fluids provided through solvent injection holes 221 and dissolved chemicals that spread off of the wafer 230 in accordance with one embodiment of the present invention. As described above, while bowl 202 is spinning during a spin coating process, the centrifugal force will ensure that the excess chemicals will be contained in cavity 250 during the spin coating process. Therefore, when a chemical, such as, photoresist is applied over a top surface 232 of wafer 230, a photoresist beading 254 will unfortunately occur at the edge of wafer 230.

To eliminate beading 254, a solvent 241 is applied from under bowl 202 against injection ring 223, through injection holes 221, and onto the back side of wafer 230. Once the solvent 241 is applied to an under surface 231 of wafer 230, the solvent material spreads in an outward manner due to the centrifugal forces of the spinning motion of bowl 202. When the solvent 241 reaches the edge of wafer 230, the solvent bead 251 is believed to interact with a beading 254 of a chemical coating 240. When solvent 241 comes in contact with beading 254, the beading 254 will begin to dissolve and fall into cavity 250. As an advantage, substantially all of the excess fluids are captured in cavity 250 during a spin coating operation, and substantially all uncontrolled solvents and coating chemicals are prevented from exiting bowl 202 where undesirable particulates may be generated.

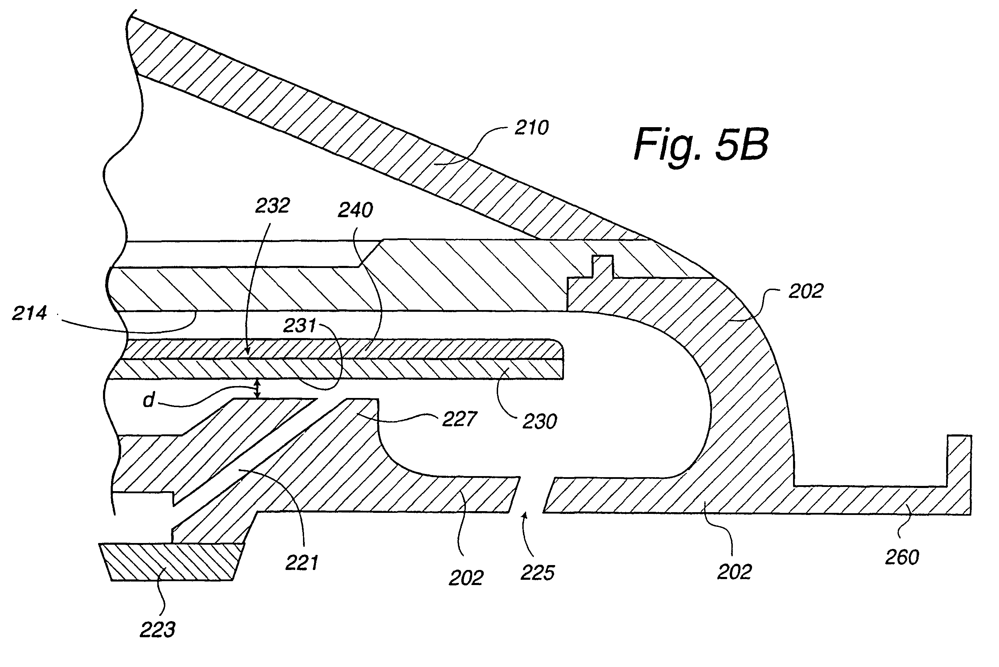

Figure 5B is a cross sectional view of the chemical coating 240 applied in a substantially uniform manner to the entire top surface of wafer 230 in accordance with one embodiment of the present invention. As described above, bowl 202 having cavity 250 advantageously reduces the amount of produced particulates during a spin coating operation. Further, the closed bowl configuration assists in maintaining coating uniformities by preventing the premature drying of the applied solvents. As a result, chemical coating 240 may be applied more evenly, while substantially preventing the yield reducing defects associated with beading and premature solvent drying.

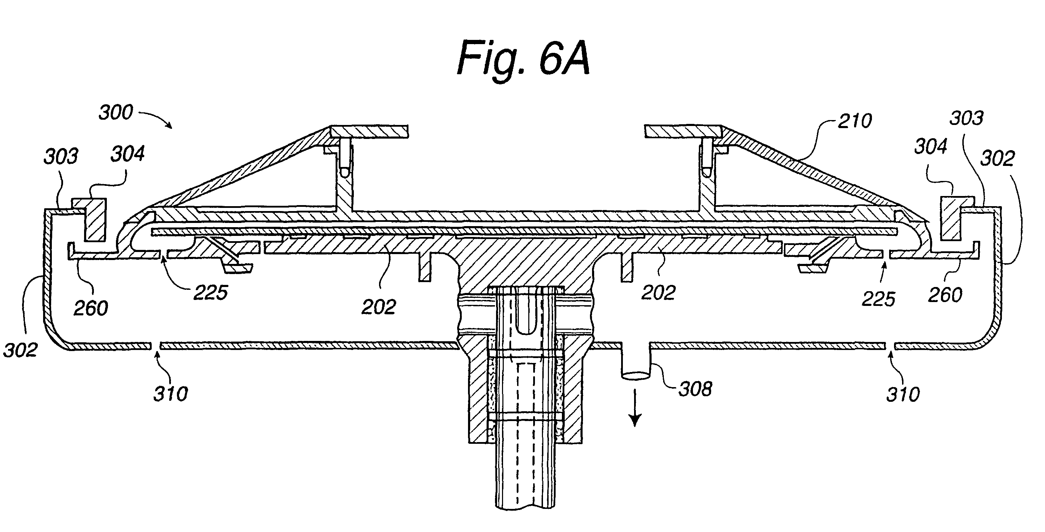

Figure 6A illustrates an exemplary spin coating system 300 that may be used to reduce particulate generation in accordance with one embodiment of the present invention. As shown, bowl 202 and lid 201 are partially contained within a catch cup 302 that includes a first splash ring 303 and a second splash ring 304. Catch cup 302 also includes exemplary floor drain holes 310 that drain chemicals that flow out of drain holes 225, and then removed to a drain manifold. An exhaust manifold 308 may also be used to assist in the removal of air borne particulates. Of course, any number of well known exhaust manifolds 308 may be implemented as well. In this embodiment, the second splash ring 304 is preferably well suited to meet circular extension 260 and form a labyrinth to substantially prevent the escape of air borne particulates into the environment surrounding the spin coating system 300.

Figure 6B is an exploded view of the exemplary spin coating system 300 illustrating the labyrinth in accordance with one embodiment of the present invention. As shown, when chemicals are being spin coated over the wafer, some chemicals may fly out of cavity 250 through the drain holes 225, causing particulates 320 to spread into catch cup 302. However, the particulates 320 that are contained within catch cup 302 are typically not a problem because they are removed by exhaust manifold 308. Because the second splash ring 304 is designed to almost contact the circular extension 260 of bowl 202, for particulates to escape, the particulates would have to traverse an unlikely path 350 before exiting the spin coating system 300.

As a result of the labyrinth created between bowl 202 and second splash ring 304, as well as the fluid capturing cavity 250, the amount of yield reducing particulates are substantially eliminated. Therefore, the closed bowl spin coating system 300 provides semiconductor manufacturers with a powerful tool for increasing yields and maintaining substantially particulate free uniform chemical coatings.

## Claims

1. A spin coating device, comprising:
means for applying a chemical fluid to be spin coated over a substrate (230) that is supported within a bowl (202) the bowl having a fluid retaining cavity (250) at an outer edge of the bowl;
encapsulating means to contain the substrate (230) in the bowl (202);
means for spinning the encapsulated bowl (202) to cause the applied chemical to be spin coated over the surface of the substrate (230);
injector means to apply a solvent to an underside edge of the substrate (230), the solvent application being configured to remove an excess chemical beading from the edge of the substrate (230); and
means for collecting the solvent and the excess chemical beading that flows off of the substrate in the fluid retaining cavity (250) while the encapsulated bowl (202) is spinning.

2. Device according to claim 1, further comprising:
drain means for removing the excess chemical beading and the solvent that is collected in the fluid retaining cavity (250) from the bowl (202) when the bowl comes to a substantial stop.

3. Device according to claim 1 or 2, further comprising:
means for cleaning an interior of the bowl (202) after each substrate (230) is spin coated.

4. Device according to claim 1, 2 or 3, further including a labyrinth defined between the bowl (202) and a catch cup splash ring (304) the labyrinth being configured to substantially prevent particulates from exiting the catch cup (302) during a spin coating operation.

5. Device according to any of claims 1 to 4, wherein the chemical is selected from the group consisting of a photoresist chemical and a spin-on-glass chemical.

6. Device according to any of claims 2 to 5, wherein
the bowl (202) has a raised support (204) for holding th substrate (230), and curved walls that define the cavity (250);
the encapsulating means comprises a lid (201) configured to mate with the curved walls, the lid having a substantially flat underside (214) that is positioned in close proximity to a top surface of the substrate (230);
the injector means comprises fluid injector holes (221) defined along an injector ring (223) that is under the substrate (230) the fluid injector holes being directed at an underside of the substrate (230) that is near the outer diameter of the substrate; and
the drain means comprises a plurality of drain holes (225) defined on a floor region of the bowl (202), the plurality of drain holes being spaced apart from the outer region of the bowl to enable the cavity (250) to hold a fluid while the bowl (202) is spinning at a high rate, and drain the fluid when the bowl slows down.

7. Device according to any of claims 1 to 6, wherein the fluid that is applied to the substrate (230) is caused to spread over the substrate by a centrifugal force when the bowl (202) is spinning, the centrifugal force further acting to hold the fluid that spreads off of the substrate in the cavity (250) while the bowl is spinning.

8. Device according to claim 6 or 7, wherein the bowl (202) includes an extension (260) defined outwardly from an outer edge of the curved walls.

9. Device according to claims 6, 7 or 8, wherein the fluid injector holes (221) are defined at an angle ranging between about 30 degrees and about 50 degrees.

10. Device according to claim 8 or 9, wherein the catch cup (302) is configured to receive the bowl (202) having the extension (260) defined outwardly from an outer edge of the curved walls, the catch cup further including at least one splash ring (304) that that defines a particulate reducing labyrinth with the extension (260).

11. Device according to any of claims 6 to 10, wherein the substantially flat underside (214) of the lid (201) is between about 2 mm and about 3 mm separated from a top surface of the substrate (230).

12. Device according to any of claims 6 to 11, further comprising a locking shaft (261) for mechanically applying the lid (201) over the bowl (202), and the locking shaft being configured to secure the lid when the bowl is spinning.

13. Device according to any of claims 1 to 12, wherein the bowl (202) includes a plurality of magnetic pads for securing the lid (201) to the bowl (202).

14. Device according to any of claims 1 to 13, wherein the cavity (250) is configured to hold a volume of between about 10 cubic centimeters and about 20 cubic centimeters.

15. Device according to any of claims 6 to 14, wherein the injector ring (223) has an internal surface that is spaced apart from the underside of the substrate (230).

16. Device according to any of claims 1 to 15, wherein the bowl (202) includes a plurality of pins (222) that are configured to mate and secure the lid (201) to the bowl (202).

17. Device according to any of claims 12 to 16, wherein the lid (201) has a hollow internal region (211) that is configured to receive the locking shaft (261).

18. Device according to any of claims 4 to 17, wherein the catch cup (302) has a draining system and an exhaust system.

19. Device according to any of claims 4 to 18, wherein the catch cup (302) includes a first splash ring (303) configured to sit over a top portion of the catch cup.

20. Device according to claim 19, wherein the catch cup (302) includes a second splash ring (304) that is configured to mate with the first splash ring (303), the second splash ring further being configured to substantially retain particulates exiting the plurality of drain holes (225) within the catch cup.

21. Device according to any of claims 1 to 20, wherein the substrate (230) is a semiconductor wafer.

22. Device according to any of claims 6 to 21, wherein the first end of the plurality of injector holes (221) is located at a first radial distance that is less than a second radial distance of the second end of the plurality of injector holes.

23. Device according to any of claims 6 to 22, wherein the plurality of drain holes (225) are defined substantially near a lower portion of the bowl (202).

24. Device according to any of claims 6 to 23, wherein the plurality of injector holes (221) are vertically lower and spaced apart from the substrate (230).

25. Device according to any of claims 1 to 24, wherein the bowl (202) contains a vacuum channel (219) for securing the substrate (230) to the bowl (202).

26. Device according to claim 25, wherein vacuum channel (219) is connected to a vacuum pump.

27. Device according to any of claims 16 to 26, wherein the lid (201) contains a plurality of pin holes configured to mate with a plurality of pins (222) defined on a top lip of the bowl (202).

28. A method for spin coating a substrate, comprising:
applying a chemical fluid to be spin coated over a substrate (230) that is supported within a bowl (202), the bowl having a fluid retaining cavity (250) at an outer edge of the bowl;
encapsulating the substrate (230) in the bowl (202);
spinning the encapsulated bowl (202) to cause the applied chemical to be spin coated over the surface of the substrate 230;
injecting a solvent in a vicinity of an underside edge of the substrate (230) to remove an excess chemical beading from the edge of the substrate; and
collecting the solvent and the excess chemical beading that flows off of the substrate (230) in the fluid retaining cavity (250) while the encapsulated bowl (202) is spinning.

29. Method according to claim 28, further comprising:
draining the excess chemical beading and the solvent that is collected in the fluid retaining cavity (250) when the encapsulated bowl (202) nears a non-spinning state.

30. Method according to claim 29, wherein the excess chemicals collected in the fluid retaining cavity (250) are drained through a plurality of drain holes (225) defined in a base region of the bowl (202).

31. Method according to claim 30, wherein the plurality of drain holes (225) are spaced apart from the outer perimeter of the bowl (202) to establish the fluid retaining cavity (250).

32. Method according to any of claims 28 to 31, wherein the fluid retaining cavity (250) is configured to hold a volume of between about 10 cubic centimeters and about 20 cubic centimeters.

33. Method according to any of claims 28 to 32, further comprising:
retarding chemical evaporation of the applied chemical when the bowl (202) is encapsulated during the spinning, the retarded chemical evaporation being configured to result in a more uniform spin coating on a top surface of the substrate (230).

34. Method according to any of claims 28 to 33, further comprising:
providing a bowl extension (260) along an outer edge of the bowl (202).

35. Method according to any of claims 28 to 34, further comprising:
providing a catch cup (302) for holding the encapsulated bowl (202) during the spinning, the catch cup having at least one splash ring;
forming a labyrinth between the at least one splash ring and the bowl extension (260), the labyrinth being configured to reduce the amount of particulates that escape the catch cup (302).

36. Method according to any of claims 28 to 35, further comprising:
cleaning the bowl (202) of excess chemicals after each spin coating operation with the solvent that is injected into the bowl.

37. Method according to any of claims 28 to 36, further comprising:
dissolving the chemical beading formed over the top surface of the substrate (230) when the solvent injected at the under surface of the substrate (230) contacts the chemical beading.

38. Method according to claim 37, wherein the dissolving of the chemical beading produces a substantially uniform chemical coating over the top surface of the substrate (230).

39. Method according to any of claims 28 to 38, wherein the spinning of the closed bowl (202) is assisted by injecting the solvent through the plurality of injector holes (221).

## Patentansprüche

1. Schleuderbeschichtungsvorrichtung mit:
einer Einrichtung zum Aufbringen einer flüssigen chemischen Substanz durch Schleuderbeschichten auf ein Substrat (230), das innerhalb einer Schale (202) aufliegt, wobei die Schale an einem äußeren Rand der Schale einen Hohlraum (250) zur Aufnahme der Flüssigkeit aufweist;
einer Kapselungseinrichtung zum Einschließen des Substrats (230) in der Schale (202);
einer Einrichtung zum schnellen Drehen der gekapselten Schale (202), so daß die aufgebrachte Chemikalie auf die Oberfläche des Substrats (230) aufgeschleudert wird;
einer Injektoreinrichtung zum Aufbringen eines Lösungsmittels auf einen Rand an der Unterseite des Substrats (230), wobei das Aufbringen des Lösungsmittels so beschaffen ist, daß ein überschüssiger Chemikalienwulst vom Rand des Substrats (230) entfernt wird; und
einer Einrichtung zum Auffangen des Lösungsmittels und des von dem Substrat abfließenden überschüssigen Chemikalienwulsts in dem Flüssigkeitsaufnahmehohlraum (250) während der schnellen Drehung der gekapselten Schale (202).

2. Vorrichtung nach Anspruch 1, die ferner aufweist:
eine Abflußeinrichtung zum Entfernen des in dem Flüssigkeitsaufnahmehohlraum (250) von der Schale (202) aufgefangenen überschüssigen Chemikalienwulsts und Lösungsmittels, wenn die Schale im wesentlichen zum Stillstand kommt.

3. Vorrichtung nach Anspruch 1 oder 2, die ferner aufweist:
eine Einrichtung zum Reinigen des Inneren der Schale (202) nach dem Schleuderbeschichten jedes Substrats (230).

4. Vorrichtung nach Anspruch 1, 2 oder 3, die ferner ein zwischen der Schale (202) und einem Auffangbecherspritzring (304) definiertes Labyrinth aufweist, wobei das Labyrinth so konfiguriert ist, daß es den Austritt von Feststoffteilchen aus dem Auffangbecher (302) während eines Schleuderbeschichtungsvorgangs weitgehend verhindert.

5. Vorrichtung nach einem der Ansprüche 1 bis 4, wobei die Chemikalie aus der Gruppe ausgewählt ist, die aus einer Photoresist-Chemikalie und einer Chemikalie zum Aufschleudern auf Glas besteht.

6. Vorrichtung nach einem der Ansprüche 2 bis 5, wobei die Schale (202) eine erhöhte Auflage (204) zur Aufnahme des Substrats (230) und gekrümmte Wände aufweist, die den Hohlraum (250) definieren;
wobei die Kapselungseinrichtung einen Deckel (201) aufweist, der so konfiguriert ist, daß er zu den gekrümmten Wänden paßt, wobei der Deckel eine im wesentlichen flache Unterseite (214) aufweist, die dicht an einer Oberseite des Substrats (230) angeordnet ist;
wobei die Injektoreinrichtung Flüssigkeitsinjektorlöcher (221) aufweist, die entlang einem Injektorring (223) definiert sind, der unter dem Substrat (230) angeordnet ist, wobei die Flüssigkeitsinjektorlöcher auf eine Unterseite des Substrats (230) nahe dem Außendurchmesser des Substrats gerichtet sind; und
wobei die Abflußeinrichtung mehrere am Bodenbereich der Schale (202) ausgebildete Abflusslöcher (225) aufweist, wobei die mehreren Abflußlöcher vom äußeren Schalenbereich beabstandet sind, um zu ermöglichen, daß der Hohlraum (250) eine Flüssigkeit aufnimmt, während sich die Schale (202) mit hoher Geschwindigkeit dreht, und die Flüssigkeit ableitet, wenn die Schale langsamer wird.

7. Vorrichtung nach einem der Ansprüche 1 bis 6, wobei bewirkt wird, daß sich die auf das Substrat (230) aufgebrachte Flüssigkeit während der schnellen Drehung der Schale (202) durch eine Zentrifugalkraft über das Substrat ausbreitet, wobei die Zentrifugalkraft ferner bewirkt, daß die vom Substrat ablaufende Flüssigkeit während der schnellen Drehung der Schale in dem Hohlraum (250) aufgefangen wird.

8. Vorrichtung nach Anspruch 6 oder 7, wobei die Schale (202) eine Erweiterung (260) aufweist, die außerhalb einer Außenkante der gekrümmten Wände ausgebildet ist.

9. Vorrichtung nach Anspruch 6, 7 oder 8, wobei die Flüssigkeitsinjektorlöcher (221) in einem Winkel ausgebildet sind, der im Bereich zwischen etwa 30 Grad und etwa 50 Grad liegt.

10. Vorrichtung nach Anspruch 8 oder 9, wobei der Auffangbecher (302) so konfiguriert ist, daß er die Schale (202) mit der außerhalb einer Außenkante der gekrümmten Wände ausgebildeten Erweiterung (260) aufnimmt, wobei der Auffangbecher ferner mindestens einen Spritzring (304) aufweist, der zusammen mit der Erweiterung (260) ein Labyrinth zur Verminderung der Feststoffteilchen definiert.

11. Vorrichtung nach einem der Ansprüche 6 bis 10, wobei die im wesentlichen flache Unterseite (214) des Deckels (201) etwa 2mm bis etwa 3 mm von einer Oberseite des Substrats (230) getrennt ist.

12. Vorrichtung nach einem der Ansprüche 6 bis 11, die ferner einen Verriegelungsschaft (261) zum mechanischen Anbringen des Deckels (201) über der Schale (202) aufweist, wobei der Verriegelungsschaft so konfiguriert ist, daß er den Deckel während der schnellen Drehung der Schale fest verschließt.

13. Vorrichtung nach einem der Ansprüche 1 bis 12, wobei die Schale (202) mehrere Magnetplatten zum Fixieren des Deckels (201) an der Schale (202) aufweist.

14. Vorrichtung nach einem der Ansprüche 1 bis 13, wobei der Hohlraum (250) so konfiguriert ist, daß er ein Volumen von etwa 10 cm³ bis etwa 20 cm³ aufnimmt.

15. Vorrichtung nach einem der Ansprüche 6 bis 14, wobei der Injektorring (223) eine Innenfläche aufweist, die von der Unterseite des Substrats (230) beabstandet ist.

16. Vorrichtung nach einem der Ansprüche 1 bis 15, wobei die Schale (202) mehrere Zapfen (222) aufweist, die so konfiguriert sind, daß sie mit dem Deckel (201) der Schale (202) zusammenpassen und diesen fest verschließen.

17. Vorrichtung nach einem der Ansprüche 12 bis 16, wobei der Deckel (201) einen hohlen inneren Bereich (211) aufweist, der so konfiguriert ist, daß er den Verriegelungsschaft (261) aufnimmt.

18. Vorrichtung nach einem der Ansprüche 4 bis 17, wobei der Auffangbecher (302) ein Abflußsystem und ein Absaugsystem aufweist.

19. Vorrichtung nach einem der Ansprüche 4 bis 18, wobei der Auffangbecher (302) einen ersten Spritzring (303) aufweist, der so konfiguriert ist, daß er über einem oberen Abschnitt des Auffangbechers sitzt.

20. Vorrichtung nach Anspruch 19, wobei der Auffangbecher (302) einen zweiten Spritzring (304) aufweist, der so konfiguriert ist, daß er mit dem ersten Spritzring (303) zusammenpaßt, wobei der zweite Spritzring ferner so konfiguriert ist, daß er aus den mehreren Abflußlöchern (225) innerhalb des Auffangbechers austretende Feststoffteilchen weitgehend zurückhält.

21. Vorrichtung nach einem der Ansprüche 1 bis 20, wobei das Substrat (230) ein Halbleiterwafer ist.

22. Vorrichtung nach einem der Ansprüche 6 bis 21, wobei das erste Ende der mehreren Injektorlöcher (221) in einem ersten radialen Abstand angebracht ist, der kleiner als ein zweiter radialer Abstand des zweiten Endes der mehreren Injektorlöcher ist.

23. Vorrichtung nach einem der Ansprüche 6 bis 22, wobei die mehreren Abflußlöcher (225) im wesentlichen in der Nähe eines unteren Abschnitts der Schale (202) definiert sind.

24. Vorrichtung nach einem der Ansprüche 6 bis 23, wobei die mehreren Injektorlöcher (221) vertikal niedriger als das Substrat (230) angeordnet und davon beabstandet sind.

25. Vorrichtung nach einem der Ansprüche 1 bis 24, wobei die Schale (202) einen Vakuumkanal (219) zum Fixieren des Substrats (230) an der Schale (202) aufweist.

26. Vorrichtung nach Anspruch 25, wobei der Vakuumkanal (219) mit einer Vakuumpumpe verbunden ist.

27. Vorrichtung nach einem der Ansprüche 16 bis 26, wobei der Deckel (201) mehrere Zapfenlöcher aufweist, die so konfiguriert sind, daß sie mit den mehreren Zapfen (222) zusammenpassen, die an einer oberen Lippe der Schale (202) ausgebildet sind.

28. Verfahren zum Schleuderbeschichten eines Substrats, mit den folgenden Schritten:
Aufbringen einer flüssigen chemischen Substanz durch Schleuderbeschichten über einem Substrat (230), das innerhalb einer Schale (202) aufliegt, wobei die Schale an einem äußeren Rand der Schale einen Flüssigkeitsrückhaltehohlraum (250) aufweist;
Einkapseln des Substrats (230) in der Schale (202);
schnelles Drehen der gekapselten Schale (202), um ein Aufschleudern der aufgebrachten Chemikalie über der Oberfläche des Substrats (230) zu bewirken;
Injektion eines Lösungsmittels in der Nähe eines Rands an der Unterseite des Substrats (230), um einen überschüssigen Chemikalienwulst vom Rand des Substrats zu entfernen; und
Auffangen des Lösungsmittels und des von dem Substrat (230) abfließenden überschüssigen Chemikalienwulsts in dem Flüssigkeitsrückhaltehohlraum (250) während der schnellen Drehung der gekapselten Schale (202).

29. Verfahren nach Anspruch 28, das ferner aufweist:
Ableiten des in dem Flüssigkeitsrückhaltehohlraum (250) aufgefangenen überschüssigen Chemikalienwulsts und Lösungsmittels, wenn sich die gekapselte Schale (202) einem langsam drehenden oder drehungsfreien Zustand nähert.

30. Verfahren nach Anspruch 29, wobei die in dem Flüssigkeitsrückhaltehohlraum (250) aufgefangenen überschüssigen Chemikalien durch mehrere, im Bodenbereich der Schale (202) ausgebildete Abflußlöcher (225) abgeleitet werden.

31. Verfahren nach Anspruch 30, wobei die mehreren Abflußlöcher (225) vom äußeren Umfang der Schale (202) beabstandet sind, um einen Flüssigkeitsrückhaltehohlraum (250) zu bilden.

32. Verfahren nach einem der Ansprüche 28 bis 31, wobei der Flüssigkeitsrückhaltehohlraum (250) so konfiguriert ist, daß er ein Volumen von etwa 10 cm³ bis etwa 20 cm³ aufnimmt.

33. Verfahren nach einem der Ansprüche 28 bis 32, das ferner aufweist:
Verzögern der Chemikalienverdunstung der aufgebrachten Chemikalie, wenn die Schale (202) während der schnellen Drehung eingekapselt wird, wobei die verzögerte Verdunstung der Chemikalie so beschaffen ist, daß sie zu einer gleichmäßigeren Schleuderbeschichtung an einer Oberseite des Substrats (230) führt.

34. Verfahren nach einem der Ansprüche 28 bis 33, das ferner aufweist:
Bereitstellen einer Schalenerweiterung (260) entlang einer Außenkante der Schale (202).

35. Verfahren nach einem der Ansprüche 28 bis 34, das ferner aufweist:
Bereitstellen eines Auffangbechers (302) zur Aufnahme der eingekapselten Schale (202) während der schnellen Drehung, wobei der Auffangbecher mindestens einen Spritzring aufweist;
Ausbilden eines Labyrinths zwischen dem mindestens einen Spritzring und der Schalenerweiterung (260), wobei das Labyrinth so konfiguriert ist, daß es die Menge der aus dem Auffangbecher (302) austretenden Feststoffteilchen verringert.

36. Verfahren nach einem der Ansprüche 28 bis 35, das ferner aufweist:
Reinigen der Schale (202) von überschüssigen Chemikalien mit dem in die Schale injizierten Lösungsmittel nach jedem Schleuderbeschichtungsvorgang.

37. Verfahren nach einem der Ansprüche 28 bis 36, das ferner aufweist:
Auflösen des über der Oberseite des Substrats (230) ausgebildeten Chemikalienwulsts, wenn das an der Unterseite des Substrats (230) injizierte Lösungsmittel in Kontakt mit dem Chemikalienwulst kommt.

38. Verfahren nach Anspruch 37, wobei das Auflösen des Chemikalienwulsts zu einem im wesentlichen gleichmäßigen Chemikalienüberzug über der Oberseite des Substrats (230) führt.

39. Verfahren nach einem der Ansprüche 28 bis 38, wobei die schnelle Drehung der geschlossenen Schale (202) durch die Injektion des Lösungsmittels durch die mehreren Injektorlöcher (221) unterstützt wird.

## Revendications

1. Dispositif de revêtement par rotation rapide, comprenant :
un moyen pour appliquer un fluide chimique devant être déposé par rotation rapide sur un substrat (230) qui est supporté dans une cuvette (202), la cuvette ayant une cavité de retenue de fluide (250) sur le bord extérieur de la cuvette ;
un moyen d'encapsulation pour contenir le substrat (230) dans la cuvette (202) ;
un moyen pour mettre en rotation rapide la cuvette (202) encapsulée pour faire que le produit chimique appliqué soit déposé par rotation rapide sur la surface du substrat (230) ;
un moyen injecteur pour appliquer un solvant sur un bord inférieur du substrat (230), l'application du solvant étant configurée pour éliminer un excès de produit chimique perlant du bord du substrat (230) ; et
un moyen pour récupérer le solvant et l'excès de produit chimique perlant qui s'écoule du substrat dans la cavité de retenue de fluide (250) lorsque la cuvette (202) encapsulée est en rotation rapide.

2. Dispositif selon la revendication 1, comprenant en outre :
un moyen de purge pour enlever le produit chimique perlant et le solvant qui sont collectés dans la cavité de retenue de fluide (250) en provenance de la cuvette (202) lorsque la cuvette vient sensiblement à l'arrêt.

3. Dispositif selon la revendication 1 ou 2, comprenant en outre :
un moyen pour nettoyer l'intérieur de la cuvette (202) après que chaque substrat (230) a été revêtu par rotation rapide.

4. Dispositif selon la revendication 1, 2 ou 3, comprenant en outre un labyrinthe défini entre la cuvette (202) et une bague anti-éclaboussures (304) de coupelle de récupération, le labyrinthe étant configuré pour éviter en grande partie que des particules ne sortent de la coupelle de récupération (302) pendant une opération de revêtement par rotation rapide.

5. Dispositif selon l'une quelconque des revendications 1 à 4, dans lequel le produit chimique est choisi dans le groupe consistant en un produit chimique photorésistant et un produit chimique de verre de rotation rapide.

6. Dispositif selon l'une quelconque des revendications 2 à 5, dans lequel la cuvette (202) a un support surélevé (204) pour maintenir le substrat (230), et des parois incurvées qui définissent la cavité (250) ;
le moyen d'encapsulation comprend un couvercle (201) configuré pour correspondre aux parois incurvées, le couvercle ayant une face inférieure (214) sensiblement plate qui est positionnée en étroite proximité avec une surface supérieure du substrat (230) ;
le moyen injecteur comprend des trous injecteurs dé fluide (221) définis le long d'une bague d'injecteur (223) qui est sous le substrat (230), les trous injecteurs de fluide étant dirigés vers une surface inférieure du substrat (230) qui est proche du diamètre extérieur du substrat ; et
le moyen de purge comprend une pluralité de trous de purge (225) définis sur une région de fond de la cuvette (202), la pluralité de trous de purge étant espacés de la région extérieure de la cuvette pour permettre à la cavité (250) de contenir un fluide tandis que la cuvette (202) est en rotation rapide, et de purger le fluide lorsque la cuvette ralentit.

7. Dispositif selon l'une quelconque des revendications 1 à 6, dans lequel le fluide qui est appliqué au substrat (230) est forcé à s'étaler sur le substrat par une force centrifuge lorsque la cuvette (202) est en rotation, la force centrifuge agissant en outre pour maintenir le fluide qui s'étale hors du substrat dans la cavité (250) tandis que la cuvette est en rotation.

8. Dispositif selon la revendication 6 ou 7, dans lequel la cuvette (202) comprend une extension (260) définie vers l'extérieur à partir d'un bord extérieur des parois incurvées.

9. Dispositif selon la revendication 6, 7 ou 8, dans lequel les trous injecteurs de fluide (221) sont définis selon un angle dans une gamme entre environ 30 degrés et environ 50 degrés.

10. Dispositif selon la revendication 8 ou 9, dans lequel la coupelle de récupération (302) est configurée pour recevoir la cuvette (202) ayant l'extension (260) définie vers l'extérieur à partir d'un bord extérieur des parois incurvées, la coupelle de récupération comprenant en outre au moins une bague anti-éclaboussures (304) qui définit un labyrinthe de réduction de particules avec l'extension (260).

11. Dispositif selon l'une quelconque des revendications 6 à 10, dans lequel la face inférieure sensiblement plate (214) du couvercle (201) est séparée entre environ 2 mm à environ 3 mm d'une surface supérieure du substrat (230).

12. Dispositif selon l'une quelconque des revendications 6 à 11, comprenant en outre un axe de verrouillage (261) pour appliquer mécaniquement le couvercle (201) sur la cuvette (202), et l'axe de verrouillage étant configuré pour immobiliser le couvercle lorsque la cuvette est en rotation.

13. Dispositif selon l'une quelconque des revendications 1 à 12, dans lequel la cuvette (202) comprend une pluralité de tampons magnétiques pour immobiliser le couvercle (201) sur la cuvette (202).

14. Dispositif selon l'une quelconque des revendications 1 à 13, dans lequel la cavité (250) est configurée de manière à contenir un volume d'entre environ 10 centimètres cube et environ 20 centimètres cube.

15. Dispositif selon l'une quelconque des revendications 6 à 14, dans lequel la bague d'injecteur (223) a une surface interne qui est espacée de la face inférieure du substrat (230).

16. Dispositif selon l'une quelconque des revendications 1 à 15, dans lequel la cuvette (202) comprend une pluralité d'ergots (222) qui sont configurés pour correspondre à et immobiliser le couvercle (201) sur la cuvette (202).

17. Dispositif selon l'une quelconque des revendications 12 à 16, dans lequel le couvercle (201) a une région interne creuse (211) qui est configurée pour recevoir l'axe de verrouillage (261).

18. Dispositif selon l'une quelconque des revendications 4 à 17, dans lequel la coupelle de récupération (302) a un système de purge et un système d'échappement.

19. Dispositif selon l'une quelconque des revendications 4 à 18, dans lequel la coupelle de récupération (302) comprend une première bague anti-éclaboussures (303) configurée pour reposer sur une portion supérieure de la coupelle de récupération.

20. Dispositif selon la revendication 19, dans lequel la coupelle de récupération (302) comprend une seconde bague anti-éclaboussures (304) qui est configurée pour correspondre à la première bague anti-éclaboussures (303), la seconde bague anti-éclaboussures étant en outre configurée pour retenir en grande partie les particules sortant de la pluralité de trous de purge (225) dans la coupelle de récupération.

21. Dispositif selon l'une quelconque des revendications 1 à 20, dans lequel le substrat (230) est une galette semi-conductrice.

22. Dispositif selon l'une quelconque des revendications 6 à 21, dans lequel la première extrémité de la pluralité de trous injecteurs (221) est positionnée à une première distance radiale qui est inférieure à une seconde distance radiale de la seconde extrémité de la pluralité de trous injecteurs.

23. Dispositif selon l'une quelconque des revendications 6 à 22, dans lequel la pluralité de trous de purge (225) sont définis sensiblement à proximité d'une portion inférieure de la cuvette (202).

24. Dispositif selon l'une quelconque des revendications 6 à 23, dans lequel la pluralité de trous injecteurs (221) sont verticalement plus bas et espacés du substrat (230).

25. Dispositif selon l'une quelconque des revendications 1 à 24, dans lequel la cuvette (202) contient un canal d'aspiration (219) pour immobiliser le substrat (230) sur la cuvette (202).

26. Dispositif selon la revendication 25, dans lequel le canal d'aspiration (219) est connecté à une pompe à vide.

27. Dispositif selon l'une quelconque des revendications 16 à 26, dans lequel le couvercle (201) comprend une pluralité de trous pour ergots configurés pour correspondre à une pluralité d'ergots (222) définis sur un couvercle supérieur de la cuvette (202).

28. Procédé de revêtement par rotation rapide d'un substrat, comprenant :
d'appliquer un fluide chimique devant être déposé par rotation rapide sur un substrat (230) qui est supporté dans une cuvette (202), la cuvette ayant une cavité de retenue de fluide (250) à un bord extérieur de la cuvette ;
d'encapsuler le substrat (230) dans la cuvette (202) ;
de mettre en rotation rapide la cuvette encapsulée (202) pour forcer le produit chimique appliqué à être déposer par rotation rapide sur la surface du substrat (230) ;
d'injecter un solvant aux alentours d'un bord de la surface inférieure du substrat (230) pour enlever un excès de produit chimique perlant du bord du substrat ; et
de récupérer le solvant et l'excès de produit chimique perlant qui s'écoulent du substrat (230) dans la cavité de retenue de fluide (250) tandis que la cuvette encapsulée (202) est en rotation rapide.

29. Procédé selon la revendication 28, comprenant en outre :
de purger l'excès de produit chimique perlant et le solvant qui sont récupérés dans la cavité de retenue de fluide (250) lorsque la cuvette encapsulée (202) approche d'un état de non rotation.

30. Procédé selon la revendication 29, dans lequel l'excès de produit chimique récupéré dans la cavité de retenue de fluide (250) est purgé via une pluralité de trous de purge (225) définis dans une région de base de la cuvette (202).

31. Procédé selon la revendication 30, dans lequel la pluralité de trous de purge (225) sont espacés du périmètre extérieur de la cuvette (202) pour établir la cavité de retenue de fluide (250).

32. Procédé selon l'une quelconque des revendications 28 à 31, dans lequel la cavité de retenue de fluide (250) est configurée de manière à contenir un volume d'entre environ 10 centimètres cube et environ 20 centimètres cube.

33. Procédé selon l'une quelconque des revendications 28 à 32, comprenant en outre :
de retarder l'évaporation chimique du produit chimique appliqué lorsque la cuvette (202) est encapsulée pendant la rotation rapide, l'évaporation chimique retardée étant configurée pour résulter en un revêtement par rotation rapide plus uniforme sur la surface supérieure du substrat (230).

34. Procédé selon l'une quelconque des revendications 28 à 33, comprenant en outre :
de disposer une extension de cuvette (260) le long d'un bord extérieur de la cuvette (202).

35. Procédé selon l'une quelconque des revendications 28 à 34, comprenant en outre :
de disposer une coupelle de récupération (302) pour maintenir la cuvette encapsulée (202) pendant la rotation, la coupelle de récupération ayant au moins une bague anti-éclaboussures ;
de former un labyrinthe entre la au moins une bague ariti-éclaboussures et l'extension de cuvette (260), le labyrinthe étant configuré pour réduire la quantité de particules qui sortent de la coupelle de récupération (302).

36. Procédé selon l'une quelconque des revendications 28 à 35, comprenant en outre :
de nettoyer la cuvette (202) de l'excès de produit chimique après chaque opération de revêtement par rotation rapide avec le solvant qui est injecté dans la cuvette:

37. Procédé selon l'une quelconque des revendications 28 à 36, comprenant en outre :
de dissoudre les perles de produit chimique formées sur la surface supérieure du substrat (230) lorsque le solvant injecté à la surface inférieure du substrat (230) vient au contact des perles de produit chimique.

38. Procédé selon la revendication 37, dans lequel la dissolution des perles de produit chimique produit un revêtement chimique sensiblement uniforme sur la surface supérieure du substrat (230).

39. Procédé selon l'une quelconque des revendications 28 à 38, dans lequel la rotation rapide de la cuvette (202) fermée est assistée en injectant le solvant par la pluralité de trous injecteurs (221).
